# Europäisches Patentamt
# European Patent Office
# Office européen des brevets

(11) Veröffentlichungsnummer: **0 438 689 B1**

(12) # EUROPÄISCHE PATENTSCHRIFT

(45) Veröffentlichungstag der Patentschrift: **22.06.94**

(51) Int. Cl.5: **G01R 19/165**

(21) Anmeldenummer: **90123755.2**

(22) Anmeldetag: **11.12.90**

(54) **Signaleinrichtung zur Anzeige des Fehlens einer elektrischen Spannung.**

(30) Priorität: **24.01.90 DE 4001913**
**25.10.90 DE 4033898**

(43) Veröffentlichungstag der Anmeldung:
**31.07.91 Patentblatt 91/31**

(45) Bekanntmachung des Hinweises auf die
Patenterteilung:
**22.06.94 Patentblatt 94/25**

(84) Benannte Vertragsstaaten:
**DE FR GB IT**

(56) Entgegenhaltungen:
**US-A- 4 030 086**
**US-A- 4 030 086**
**US-A- 4 491 807**

**RADIO AND ELECTRONICS CONSTRUCTOR,
Band 28, Nr. 11, Juni 1975, Seiten
686-687,Data Publishers Ltd, London, GB;
N.R. WILSON: "Mains failure monitor"**

**IDEMIEE SPECTRUM, Band 7, Nr. 10, Oktober
1970, Seite 88; "Schmitt trigger built asa
monolithic integrated circuit has advantages
over discrete wired devices"**

(73) Patentinhaber: **DIEHL GMBH & CO.**
**Stephanstrasse 49**
**D-90478 Nürnberg(DE)**

(72) Erfinder: **Stürzl, Wilhelm**
**Wiesenstrasse 12**
**W-8501 Winkelhaid(DE)**
Erfinder: **Höber, Joachim**
**Am Oberen Tor 2**
**W-8557 Eggolsheim(DE)**

**Beschreibung**

Die Erfindung betrifft eine Signaleinrichtung zur Anzeige des Fehlens einer elektrischen Spannung, insbesondere einer Versorgungsnetzspannung für ein elektrisches Gerät, wobei die Signaleinrichtung zwei Spannungsanschlüsse und ein Ahzeigeorgan aufweist und wobei zwischen den beiden Spannungsanschlüssen als Energiespeicher ein Ladekondensator eingeschaltet ist, wobei zum Ladekondensator eine einen Ausgang aufweisende Schwingschaltung parallel geschaltet ist, die mit einem zur Abgabe akustischer Signalimpulse vorgesehenen, das Anzeigeorgan bildenden Signalelement elektrisch leitend in Verbindung steht, wobei die Schwingschaltung beim Fehlen der elektrischen Spannung zwischen den beiden Spannungsanschlüssen aus dem Ladekondensator mit Energie versorgt wird und Triggerspannungsimpulse abgibt.

Eine solche Signaleinrichtung ist aus Radio and Electronics Constructor, Band 28, Nr.11, 1975, Seiten 686-687 bekannt.

Bei bekannten Signaleinrichtungen zur Anzeige des Fehlens einer elektrischen Spannung ist das Anzeigeorgan üblicherweise eine Lampe, die bei Spannungsausfall, d.h. beim Fehlen der elektrischen Spannung, aufleuchtet. Ein derartiges Aufleuchten des Anzeigeorgans ist jedoch nur feststellbar, wenn das Anzeigeorgan gezielt beobachtet wird, bzw. wenn es zumindest im Gesichtsfeld eines Beobachters angeordnet ist.

Der Erfindung liegt die Aufgabe zugrunde, eine Signaleinrichtung der eingangs genannten Art zu schaffen, mit welcher das Fehlen einer elektrischen Spannung auch dann feststellbar ist, wenn sich das Anzeigeorgan nicht im Gesichtsfeld eines Beobachters befindet, und die einfach ausgebildet ist und die demzufolge geringe Herstellungskosten aufweist.

Die der Erfindung gestellte Aufgabe kann dadurch gelöst werden, daß der Ausgang (26) der Schwingschaltung (22) mit einer einen Ausgang (30) aufweisenden Verstärkerschaltung (24) verbunden ist und daß der Ausgang der Verstärkerschaltung mit dem Signalelement verbunden ist und daß die Schwingschaltung (22) ein invertierendes Schwellwert-Gatter (82) aufweist, zu dem ein Widerstand (88), außerdem eine Reihenschaltung aus einem Vorwiderstand (90) und einer Diode (92) parallelgeschaltet sind, und daß an der Eingangsseite ein Abblockkondensator (94) vorgesehen ist.

Eine derartige Signaleinrichtung weist die Vorteile eines im Vergleich zur oben genannten Ausbildung der Signaleinrichtung erweiterten Spannungsbereiches, einer längeren Laufzeit, einer erhöhten Lautstärke des Signalelementes, d.h. des Summers, sowie reduzierter Herstellungskosten infolge eines wesentlich vereinfachten Aufbaues auf.

Weitere Einzelheiten, Merkmale und Vorteile der Erfindung ergeben sich aus der nachfolgenden Beschreibung von einem in der Zeichnung dargestellten Ausführungsbeispiel. Die Figur zeigt eine Ausbildung des Schaltungsschemas der Signaleinrichtung.

Die Figur zeigt das Schaltungsschema einer Ausbildung der Signaleinrichtung 10 mit einer Schwingschaltung 22 und einer Verstärkerschaltung 24 sowie einem akustischen Signalelement 32. Zwischen zwei Spannungsanschlüssen 12 und 14 der Signaleinrichtung 10 ist ein Ladekondensator 20 eingeschaltet, dem zum Spannungsanschluss 12 hin eine Diode 18 und ein Vorwiderstand 74 in Reihe vorgeschaltet ist. Eine Zenerdiode 70 ist einseitig zwischen dem Vorwiderstand 74 und die Diode 18 eingeschaltet, der zweite Anschluss der Zenerdiode 70 ist mit dem Spannungsanschluss 14 verbunden. Zwischen dem Vorwiderstand 74 und der Diode 18 ist eine Diode 76 mit ihrem einen Anschluss angeschlossen, deren zweiter Anschluss mit einem Widerstand 78 in Reihe geschaltet ist. Der zweite Anschluss des Widerstandes 78 ist mit einem Eingang 80 der Schwingschaltung 22 kontaktiert. Die Schwingschaltung 22 weist einen Ausgang 26 auf, der mit einem Eingang 28 der Verstärkerschaltung 24 über einen Widerstand 54 verbunden ist. Die Verstärkerschaltung 24 weist einen Ausgang 30 auf, an den einpolig das akustische Signalelement 32 angeschlossen ist. Die Verstärkerschaltung 24 weist einen Transistor 56 auf, dessen Basis den Eingang 28 der Verstärkerschaltung 24 bildet, dessen Emitter auf dem Potential des Spannungsanschlusses 14 liegt, und dessen Kollektor den Ausgang 30 der Verstärkerschaltung 24 bildet.

Die Schwingschaltung 22 weist ein invertierendes Schwellwert-Gatter 82 mit Eingängen 84 und einen Ausgang 86 auf, der mit dem Ausgang 26 der Schwingschaltung 22 kontaktiert ist. Zwischen den Eingängen 84 und dem Ausgang 86 ist zum Schwellwert-Gatter 82 ein Widerstand 88 sowie eine Serienschaltung aus einem Vorwiderstand 90 und einer Diode 92 parallelgeschaltet. Ein Abblockkondensator 94 ist einseitig mit den Eingängen 84 bzw. dem Eingang 80 der Schwingschaltung 22 und andererseits mit dem Spannungsanschluss 14 kontaktiert.

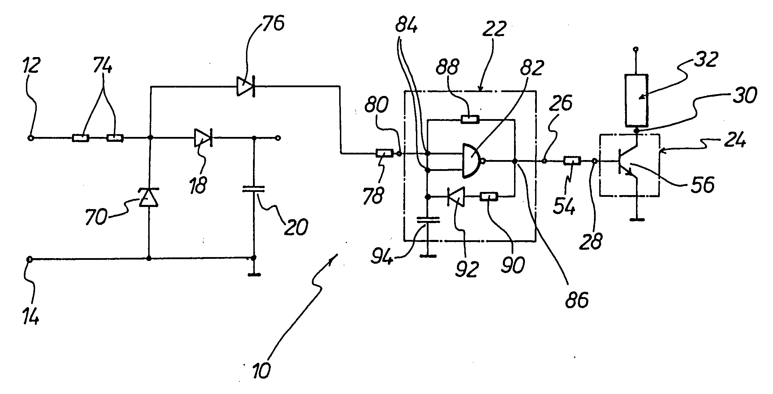

In der nachfolgenden Tabelle werden die Werte bzw. die Bezeichnungen der in der in Fig. 2 dargestellten Schaltung für die Signaleinrichtung 10 zur Anwendung gelangenden elektronischen Komponenten aufgeführt.

2

Tabelle:

| Bezeichnung | Bezugsziffer | Wert bzw. Typenbez. |
|---|---|---|
| Vorwiderstand | 74 | 2 x 100 k |
| Diode | 70 | z 5,6 |
| Diode | 18 | 1 N 4148 |
| Ladekondensator | 20 | 0,47 F |
| Diode | 76 | 1 N 4148 |
| Widerstand | 78 | 100 k |
| invertierendes Schwellwert-Gatter | 82 | 4093 |
| Widerstand | 88 | 2,7 M |
| Vorwiderstand | 90 | 47 k |
| Diode | 92 | 1 N 4148 |
| Abblockkondensator | 94 | 4,7 µF |
| Widerstand | 54 | 47 k |
| Transistor | 56 | BC 547 A |

Mit der gezeichneten Signaleinrichtung 10 ergibt sich mit dem akustischen Signalelement 32, d.h. mit dem Summer, eine gepulste Tonfolge mit einer Impulsdauer von ca. 50 msec und einer Zeitspanne zwischen aufeinanderfolgenden Impulsen von grössenordnungsmässig 2 sec.

**Patentansprüche**

1. Signaleinrichtung zur Anzeige des Fehlens einer elektrischen Spannung, insbesondere einer Versorgungsnetzspannung für ein elektrisches Gerät, wobei die Signaleinrichtung (10) zwei Spannungsanschlüsse (12,14) und ein Anzeigeorgan aufweist, und wobei zwischen den beiden Spannungsanschlüssen (12,14) als Energiespeicher ein Ladekondensator (20) eingeschaltet ist, wobei zum Ladekondensator (20) eine einen Ausgang (26) aufweisende Schwingschaltung (22) parallelgeschaltet ist, die mit einem zur Abgabe akustischer Signalimpulse vorgesehenen, das Anzeigeorgan bildenden akustischen Signalelement (32) elektrisch leitend in Verbindung steht, wobei die Schwingschaltung (22) beim Fehlen der elektrischen Spannung zwischen den beiden Spannungsanschlüssen (12,14) aus dem Ladekondensator (20) mit Energie versorgt wird und Triggerspannungsimpulse abgibt,
dadurch gekennzeichnet,
daß der Ausgang (26) der Schwingschaltung (22) mit einer einen Ausgang (30) aufweisenden Verstärkerschaltung (24) verbunden ist, und daß der Ausgang (30) der Verstärkerschaltung (24) mit dem Signalelement verbunden ist und daß die Schwingschaltung (22) ein invertierendes Schwellwert-Gatter (82) aufweist, zu dem ein Widerstand (88), außerdem eine Reihenschaltung aus einem Vorwiderstand (90) und einer Diode (92) parallelgeschaltet sind, und daß an der Eingangsseite ein Abblockkondensator (94) vorgesehen ist.

2. Signaleinrichtung nach Anspruch 1,
dadurch gekennzeichnet,
daß die Verstärkerschaltung (24) einen Transistor (56) aufweist, dessen Basis mittels eines Vorschaltwiderstandes (54) mit dem Ausgang (26) der Schwingschaltung (22) verbunden ist.

## Claims

1. A signalling device for indicating the lack of a voltage, in particular of a supply mains voltage for an electrical appliance, in which respect the signalling device (10) has two voltage connections (12,14) and an indicator member, and in which respect connected between the two voltage connections (12,14) as energy store is a charging capacitor (20), in which respect connected in parallel with the charging capacitor (20) is an oscillatory circuit (22) which has an output (26) and which communicates in an electrically conductive manner with an acoustic signalling element (32) which is provided for the delivery of acoustic signal pulses and which forms the indicator member, in which respect the oscillatory circuit (22) upon lack of the electrical voltage between the two voltage connections (12,14) is supplied with energy from the charging capacitor (20) and delivers voltage pulses, characterised in that the output (26) of the oscillatory circuit (22) is connected to an amplifier circuit (24) which has an output (30), and in that the output (30) of the amplifier circuit (24) is connected to the signalling element and in that the oscillatory circuit (22) has an inverting threshold-value gate (82), with which a resistor (88), moreover a series connection consisting of a series resistor (90) and a diode (92), are connected in parallel and in that a blocking capacitor (94) is provided on the input side.

2. A signalling device according to claim 1, characterised in that the amplifier circuit (24) has a transistor (56), the base of which is connected by means of a series resistor (54) to the output (26) of the oscillatory circuit (22).

## Revendications

1. Dispositif de signalisation pour l'indication de l'absence d'une tension électrique, en particulier d'une tension d'alimentation par le réseau d'un appareil électrique, le dispositif de signalisation (10) comportant deux branchements de tension (12, 14) et un organe d'indication, et un condensateur de charge (20) étant monté entre les deux branchements de tension (12, 14) en tant qu'accumulateur d'énergie, un circuit oscillant (22), présentant une sortie (26), étant monté en parallèle au condensateur de charge (20), lequel circuit oscillant étant relié, de manière électriquement conductrice, avec un élément de signalisation (32) acoustique, formant l'organe d'indication, prévu pour délivrer des impulsions de signalisation acoustique, le circuit oscillant (22) étant alimenté en énergie à partir du condensateur de charge (20), en l'absence de la tension électrique entre les deux branchements de tension (12, 14) et délivrant des impulsions de tension de déclenchement, caractérisé en ce que la sortie 26 du circuit oscillant (22) est reliée à un circuit amplificateur (24), présentant une sortie (30), et en ce que la sortie (30) du circuit amplificateur (24) est reliée à l'élément de signalisation et en ce que le circuit oscillant (22) comporte une porte de valeur seuil (82) d'inversion, en parallèle à laquelle sont montés une résistance et un circuit série constitué d'une résistance série (90) et d'une diode (92), et en ce qu'un condensateur de déblocage (94) est prévu côte entrée.

2. Dispositif de signalisation selon la revendication 1, caractérisé en ce que le circuit amplificateur (24) comporte un transistor (56) dont la base est reliée au moyen d'une résistance amont (54) avec la sortie (26) du circuit oscillant (22).